**Europäisches Patentamt**

**European Patent Office**

**Office européen des brevets**

(19)

(11) **EP 1 302 988 A2**

(12) **EUROPÄISCHE PATENTANMELDUNG**

(43) Veröffentlichungstag:
  **16.04.2003 Patentblatt 2003/16**

(51) Int Cl.⁷: **H01L 31/048**

(21) Anmeldenummer: **02021860.8**

(22) Anmeldetag: **30.09.2002**

(84) Benannte Vertragsstaaten:
  **AT BE BG CH CY CZ DE DK EE ES FI FR GB GR
  IE IT LI LU MC NL PT SE SK TR**
  Benannte Erstreckungsstaaten:
  **AL LT LV MK RO SI**

(30) Priorität: **12.10.2001 DE 10150515**

(71) Anmelder: **Bayer Aktiengesellschaft
  51368 Leverkusen (DE)**

(72) Erfinder:
  • **Stollwerck, Gunther, Dr.
    47800 Krefeld (DE)**
  • **Hässler, Christian, Dr.
    47800 Krefeld (DE)**
  • **Foltin, Eckard
    53489 Sinzig (DE)**
  • **Opelka, Gerhard
    51381 Leverkusen (DE)**
  • **Post, Bernd
    47441 Moers (DE)**
  • **Hättig, Jürgen
    51519 Odenthal (DE)**

(54) **Photovoltaik-Module mit einer thermoplastischen Schmelzklebeschicht sowie ein Verfahren zu ihrer Herstellung**

(57)    Die Erfindung betrifft Photovoltaik-Module mit einer speziellen thermoplastischen Klebeschicht wobei die Kunststoffklebeschicht aus einem aliphatischen thermoplastischen Polyurethan mit einer Härte von 75 Shore A bis 70 Shore D, vorzugsweise 92 Shore A bis 70 Shore D und mit einer Erweichungstemperatur $T_{erw}$ von 90° bis 150°C bei einem E'-Modul von 2MPa (gemessen nach der DMS-Methode) besteht, welches ein Reaktionsprodukt ist aus einem aliphatischen Diisocyanat (A), mindestens einem zerewitinoff-aktiven Polyol mit im Mittels mindestens 1,8 bis höchstens 3,0 zerewitinoff-aktiven Wasserstoffatomen und mit einem zahlenmittleren Molekulargewicht von 600 bis 10000g/mol und mindestens einem zerewitinoff-aktiven Polyol mit im Mittel mindestens 1,8 bis höchtens 3,0 zerewitinoff-aktiven Wasserstoffatomen und mit einem zahlenmittleren Molekulargewicht von 60 bis 500g/mol als Kettenverlägerer, wobei das Molverhältnis der den NCO-Gruppen des aliphatischen Diisocyanats zu den OH-Gruppen des Kettenverlängerers und des Polyols 0,85 bis 1,2, bevorzugt 0,9 bis 1,1 beträgt.

# Fig. 1

Erfindungsgemäßes Solarmodul mit Abdeckplatte und Rückseitenfolie

EP 1 302 988 A2

## Beschreibung

Die Erfindung betrifft Photovoltaik-Module mit einer speziellen thermoplastischen Klebeschicht und ihre Herstellung.

Unter Photovoltaikmodulen oder Solarmodulen versteht man photovoltaische Bauelemente zur direkten Erzeugung von elektrischem Strom aus Licht, insbesondere Sonnenlicht. Schlüsselfaktoren für eine kosteneffiziente Erzeugung von Solarstrom sind der Wirkungsgrad der verwendeten Solarzellen sowie die Herstellkosten und die Haltbarkeit der Solarmodule.

Ein Solarmodul besteht üblicherweise aus einem Verbund aus Glas, verschalteten Solarzellen, einem Einbettmaterial und einer Rückseitenkonstruktion. Die einzelnen Schichten des Solarmoduls haben folgende Funktionen zu erfüllen:

Das Frontglas (Deckschicht) dient dem Schutz vor mechanischen und Witterungseinflüssen. Es muss höchste Transparenz aufweisen, um Absorptionsverluste im optischen Spektralbereich von 350 nm bis 1150 nm und damit Wirkungsgradverluste der üblicherweise zur Stromerzeugung eingesetzten Silicium-Solarzellen möglichst gering zu halten. Normalerweise wird gehärtetes, eisenarmes Weißglas (3 oder 4 mm stark) verwendet, dessen Transmissionsgrad im vorgenannten Spektralbereich bei 90 bis 92 % liegt.

Das Einbettmaterial (zumeist werden EVA (Ethyl-Vinylacetat)-Folien verwendet) dient zur Verklebung des Modulverbundes. EVA schmilzt während des Laminiervorgangs bei etwa 150°C, fließt dadurch auch in die Zwischenräume der verlöteten oder mit leitfähigen Klebstoffen verbundenen Solarzellen und wird dabei thermisch vernetzt. Die Bildung von Luftblasen, die zu Reflexionsverlusten führen, wird durch eine Laminierung unter Vakuum und mechanischem Druck vermieden.

Die Modulrückseite schützt die Solarzellen und das Einbettmaterial vor Feuchtigkeit und Sauerstoff. Außerdem dient sie als mechanischer Schutz vor Verkratzen etc. beim Montieren der Solarmodule und als elektrische Isolierung. Die Rückseitenkonstruktion kann entweder ebenfalls aus Glas bestehen, häufig aber aus einer Verbundfolie. Im Wesentlichen werden bei der Verbundfolie die Varianten PVF (Polyvinylfluorid)-PET (Polyethylenterephthalat)-PVF oder PVF-Aluminium-PVF eingesetzt.

Die im Solarmodulbau eingesetzten sogenannten Kapselungsmaterialien (für die Modulvorderseite und -rückseite) müssen insbesondere gute Barriereeigenschaften gegen Wasserdampf und Sauerstoff aufweisen. Durch Wasserdampf oder Sauerstoff werden die Solarzellen selbst nicht angegriffen, aber es kommt zu einer Korrosion der Metallkontakte und einer chemischen Degradation des EVA-Einbettmaterials. Ein zerstörter Solarzellenkontakt führt zu einem Komplettausfall des Moduls, da normalerweise alle Solarzellen in einem Modul elektrisch seriell verschaltet werden. Eine Degradation des EVA zeigt sich an einer Vergilbung des Moduls, verbunden mit einer entsprechenden Leistungsreduktion durch Lichtabsorption sowie einer visuellen Verschlechterung. Heute werden etwa 80 % aller Module mit einer der beschriebenen Verbundfolien auf der Rückseite verkapselt, bei etwa 15 % der Solarmodule wird Glas für Vorder- und Rückseite verwendet. Im letzteren Fall kommen als Einbettmaterial anstelle von EVA teilweise hochtransparente, allerdings nur langsam (mehrere Stunden) härtende Gießharze zum Einsatz.

Um trotz der relativ hohen Investitionskosten konkurrenzfähige Stromgestehungskosten von Solarstrom zu erreichen, müssen Solarmodule lange Betriebszeiten erreichen. Heutige Solarmodule sind daher auf eine Lebensdauer von 20 bis 30 Jahren ausgelegt. Neben hoher Witterungsstabilität werden große Anforderungen an die Temperaturbelastbarkeit der Module gestellt, deren Temperatur im Betrieb zyklisch zwischen +80°C bei voller Sonneneinstrahlung und Temperaturen unterhalb des Gefrierpunkts (nachts) schwanken kann. Dementsprechend werden Solarmodule umfangreichen Stabilitätstests unterzogen (Normtests nach IEC 6 12 15), zu denen Witterungstests (UV-Bestrahlung, Damp Heat, Temperaturwechsel), aber auch Hagelschlagtests und Tests bezüglich des elektrischen Isolierungsvermögens zählen.

Auf den Modulbau entfällt mit 30 % der Gesamtkosten ein relativ hoher Anteil der Herstellkosten für Photovoltaikmodule. Dieser große Anteil der Modulfertigung ist durch hohe Materialkosten (hagelschlagsicheres 3 bis 4 mm starkes Frontglas, Verbundfolie auf der Rückseite) und durch lange Prozesszeiten, d.h. geringe Produktivität bedingt. Noch immer werden die oben beschriebenen Einzelschichten des Modulverbunds in Handarbeit zusammengestellt und ausgerichtet. Zusätzlich führt das Aufschmelzen und das relativ langsame Vernetzen des EVA-Schmelzklebers und die Laminierung des Modulverbunds bei ca. 150°C und unter Vakuum zu Zykluszeiten von etwa 20 bis 30 Minuten pro Modul.

Durch die relativ dicke Frontglasscheibe (3 bis 4 mm) weisen konventionelle Solarmodule zudem ein hohes Gewicht auf, das wiederum stabile und teure Haltekonstruktionen nötig macht. Auch ist die Wärmeabfuhr bei heutigen Solarmodulen nur unbefriedigend gelöst. Bei voller Sonnenbestrahlung heizen sich die Module bis zu 80°C auf, was zu einer temperaturbedingten Verschlechterung des Solarzellenwirkungsgrads und damit letztlich zu einer Verteuerung des Solarstroms führt.

Verschiedene Ansätze zu Reduktion der Modulherstellkosten durch kostengünstigere Herstellverfahren konnten sich bisher nicht durchsetzen. In der Patentanmeldung WO 94/22 172 wird die Verwendung eines Rollenlaminators anstelle des bisher eingesetzten Vakuumplattenlaminators (Vakuumheißpresse) beschrieben, wobei die verwendeten Kunststofffolien nur bedingt für die Verkapselung von Solarmodulen geeignet sind. Die genannten Folien sind weder schlagzäh genug noch ausreichend witterungsstabil, noch ist die Klebschicht weich genug, um die leicht zerbrechlichen Solarzellen effektiv mechanisch zu schützen.

In den Patentanmeldungen JP-A 09-312410 und JP-A 09-312408 wird die Verwendung von thermoplastischen Polyurethanen (TPU) bzw. Elastomeren als Klebschicht für die Solarmodule beschrieben. Die Solarmodule sind für den Einsatz in Solarautos vorgesehen. Die Solarzellen müssen daher vor Vibration geschützt werden. Dies wird durch extrem weiche TPU erreicht, die deutlich weicher als EVA sind. Die Verklebung erfolgt mit Hilfe eines Vakuumlaminators, der wie oben bereits beschrieben, lange Prozesszeiten benötigt. Ab einer Modulgröße von 2 m$^2$ ist ein Vakuumlaminator außerdem nicht mehr einsetzbar, da der Weg der Luftblasen bis zum Entweichen am Rand zu groß ist, so dass sie in der üblichen Prozesszeit nicht mehr Entweichen können und im Klebstoff "eingefroren" werden. Dadurch kommt es zu Reflexionsverlusten. Die in JP-A 09-312410 beschriebenen thermoplastischen Polyurethane erweichen zwar bei der Erwärmung im Vakuumlaminator, jedoch werden sie nicht ausreichend flüssig, dass die Zwischenräume zwischen den Solarzellen ausgefüllt werden. Dadurch erhält man unbrauchbare Solarmodule.

In den Anmeldungen WO 99/52153 und WO 99/52154 wird die Verwendung von Verbundfolien bzw. Verbundkörpern aus einer Polycarbonatschicht und einer Fluorpolymerschicht für die Verkapselung von Solarmodulen beansprucht. Zur Verklebung wird der nur langsam zu verarbeitende EVA-Schmelzklebstoff verwendet.

In der Anmeldung DE-A 3 013 037 wird ein symmetrischer Aufbau eines Solarmoduls mit einer PC-Platte auf Vorder- und Rückseite beschrieben, wobei die Einbettungsschicht (Klebschicht) für die Solarzellen durch einen maximalen E-Modul von 1 000 MPa charakterisiert ist, was viel zu hart ist und die zerbrechlichen Solarzellen bei der Wärmeausdehnung zerreißt.

EVA als Schmelzklebstoff muss bei etwa 150°C aufgeschmolzen werden; dabei ist EVA wasserflüssig. Ist nun eine Modulkonstruktion sehr schwer, so wird in diesem Zustand das EVA während des Laminierens zur Seite herausgedrückt und die effektive Klebschichtdicke verringert sich entsprechend. Der Vernetzungsprozess setzt bei etwa 150°C ein und benötigt zwischen 15 und 30 Minuten. Aufgrund dieser langen Prozesszeit ist EVA nur in einem Vakuumlaminator diskontinuierlich zu verarbeiten. Das Verarbeitungsfenster (zeitabhängiger Druck- und Temperaturverlauf) ist für EVA sehr eng. Darüber hinaus zeigt EVA unter UV-Bestrahlung Vergilbung, der z.B. durch die Dotierung mit Cer als UV-Absorber in der darüber liegenden Glasscheibe Rechnung getragen wird [F.J. Pern, S.H. Glick, Sol. Energy Materials & Solar Cells 61 (2000), Seiten 153-188].

Kunststoffe haben einen wesentlich höheren Wärmeausdehnungskoeffizienten 50 bis 150·10$^{-6}$ K$^{-1}$) als Silicium (2·10$^{-6}$ K$^{-1}$) oder Glas (4*10$^{-6}$ K$^{-1}$). Werden Solarzellen also mit Kunststoffen verkapselt und nicht mit Glas, so müssen die Silicium-Solarzellen von dem Kunststoff durch eine geeignete, weiche Klebschicht mechanisch entkoppelt werden. Die Klebschicht darf aber auch nicht zu weich sein, um dem ganzen Solarmodulverbund noch ausreichende mechanische Verwindungssteifigkeit zu geben. EVA löst dieses Problem der unterschiedlichen Ausdehnungskoeffizienten von Silicium und Kunststoffen bzw. der Verwindungssteifigkeit nur ungenügend.

Aufgabe der Erfindung war es, Photovoltaikmodule, die sich durch ein schnelles und kostengünstiges Verfahren zu ihrer Herstellung sowie ein niedriges Gewicht auszeichnen, zur Verfügung zu stellen.

Diese Aufgabe konnte mit den erfindungsgemäßen Photovoltaik-Modulen gelöst werden.

Gegenstand der Erfindung sind Photovoltaik-Module mit folgendem Aufbau

A) mindestens einer vorderseitigen, der Energiequelle zugewandten, äußeren Abdeckschicht aus Glas oder einem schlagzähen, UV-stabilen, witterungsstabilen, transparenten Kunststoff mit geringer Wasserdampfdurchlässigkeit,

B) mindestens einer zwischen A) und C) befindlichen Kunststoffklebeschicht, in die mindestens eine oder mehrere Solarzellen, die untereinander elektrisch verbunden sind, eingebettet sind,

C) mindestens einer rückseitigen, der Energiequelle abgewandten, äußeren Schicht aus Glas oder einem witterungsstabilen Kunststoff mit niedriger Wasserdampfdurchlässigkeit,

welche dadurch gekennzeichnet sind, dass die Kunststoffklebeschicht in B) aus einem aliphatischen thermoplastischen Polyurethan mit einer Härte von 75 Shore A bis 70 Shore D, vorzugsweise 92 Shore A bis 70 Shore D und mit einer Erweichungstemperatur $T_{erw}$ von 90° bis 150°C bei einem E'-Modul von 2 MPa (gemessen nach der DMS-Methode) besteht, welches ein Reaktionsprodukt ist aus einem aliphatischen Diisocyanat (A), mindestens einem zerewitinoff-aktiven Polyol mit im Mittel mindestens 1,8 bis höchstens 3,0 zerewitinoff-aktiven Wasserstoffatomen und mit einem zahlenmittleren Molekulargewicht von 600 bis 10 000 g/mol (B) und mindestens einem zerewitinoff-aktiven Polyol mit im Mittel mindestens 1,8 bis höchstens 3,0 zerewitinoff-aktiven Wasserstoffatomen und mit einem zahlenmittleren Molekulargewicht von 60 bis 500 g/mol als Kettenverlängerer (C), wobei das Molverhältnis der den NCO-Gruppen des aliphatischen Diisocyanats zu den OH-Gruppen des Kettenverlängerers (C) und des Polyols (B) 0,85 bis 1,2, bevorzugt 0,9 bis 1,1 beträgt.

DMS-Methode (Dynamisch-mechanische Analyse im Zugmodus)

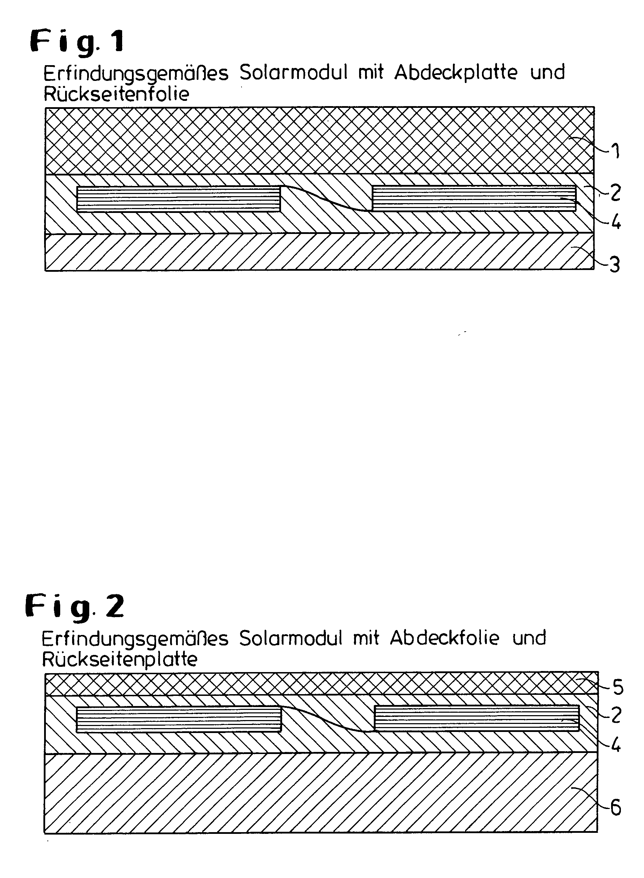

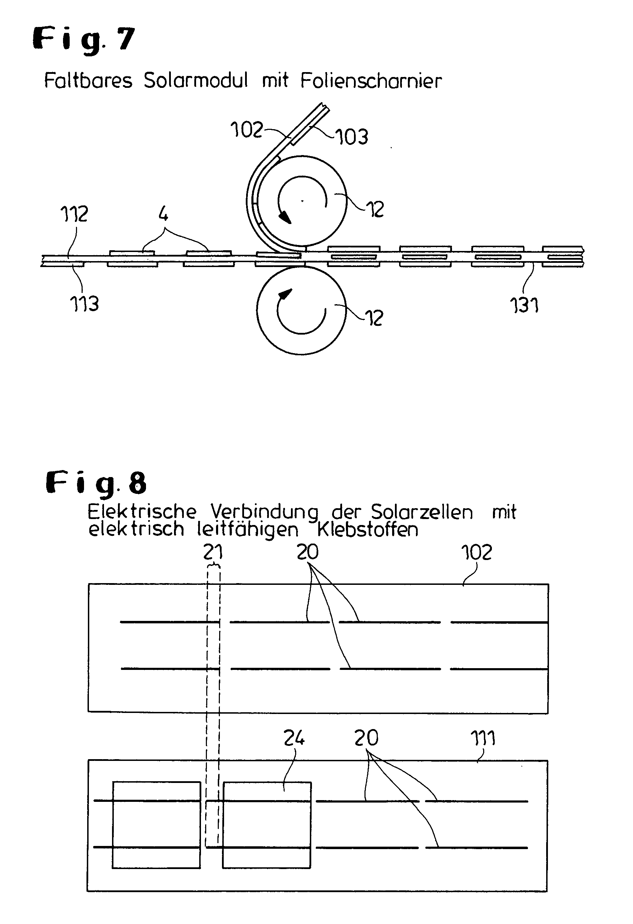

Aus Spritzplatten wurden Rechtecke (30 mm x 10 mm x 1 mm) gestanzt. Diese Prüfplatten wurden unter konstanter Vorlast - gegebenenfalls vom Speichermodul abhängig - periodisch mit sehr kleinen Deformationen angeregt und die auf die Einspannung einwirkende Kraft als Funktion der Temperatur und Anregungsfrequenz gemessen.
Die zusätzlich aufgebrachte Vorlast dient dazu, im Zeitpunkt negativer Deformationsamplitude die Probe noch ausreichend gespannt zu halten.
Die Erweichungstemperatur $T_{erw}$ wurde als charakteristische Temperatur für den Wärmestand bei E'= 2 MPa bestimmt.
Die DMS-Messungen wurden mit dem Seiko DMS Modell 210 der Firma Seiko mit 1 HZ im Temperaturbereich bon -150°C bis 200°C mit einer Heizrate von 2°C/min durchgeführt.
Die Abdeckschicht A) besteht vorzugsweise aus einer Platte oder aus einer oder mehreren Folien.
Die Schicht C) besteht bevorzugt aus einer Platte oder aus einer oder mehreren Folien.
Bei der Abdeckschicht A) handelt es sich vorzugsweise um eine in Streifen vorliegende Folie oder Platte, wobei die Streifen über den sogenannten Solarzellenstrings angeordnet sind.
Die in der Kunststoffklebeschicht B) eingebetteten Solarzellen sind bevorzugt in Solarzellenstrings angeordnet.
Bevorzugt sind die Solarzellenstrings seriell verlötet oder mit leitfähigen Klebstoffen verbunden, um eine möglichst hohe elektrische Spannung mit den Solarzellen zu erzeugen.
Bei der Verwendung von leitfähigen Klebstoffen sind diese vorzugsweise als sogenannte Klebstoffraupen (Kleben, Grundlagen-Technologie-Anwendungen, Handbuch Münchener Ausbildungsseminar Axel Springer Verlag Berlin, Heidelberg 1997) (20) direkt auf der Innenseite der Kunststoffklebeschicht (102, 111) so positioniert, dass sie beim Laminieren direkt auf die entsprechenden Kontakte der Solarzellen (24) treffen und einen Überlappungsbereich (21) aufweisen, der die serielle Verschaltung der Solarzellen ermöglicht (siehe Fig. 8). Dadurch kann das Verlöten vor dem Laminieren entfallen, und die elektrische Verbindung sowie die Verkapselung werden in einem Schritt durchgeführt.
Bevorzugt befindet sich zwischen der Abdeckschicht (A) und den Solarzellen in der Kunststoffklebeschicht (B) zusätzlich eine Glasfolie mit einer Dicke von weniger als 500 µm.
Das erfindungsgemäße Solarmodul besteht vorzugsweise aus einer vorderseitigen, transparenten Abdeckkung (1, 5), einer die Solarzellen (4) umhüllenden Klebschicht (2) sowie einer Rückseite (3, 6), die opak oder transparent sein kann (siehe Fig. 1 und Fig. 2). Die Abdeckung sollte folgende Eigenschaften aufweisen: hohe Transparenz von 350 nm bis 1 150 nm, hohe Schlagzähigkeit, UV- und Witterungsstabilität, geringe Wasserdampfdurchlässigkeit.
Die Abdeckung (1, 5) kann aus folgenden Materialien bestehen: Glas, Polycarbonat, Polyester, Polyvinylchlorid, fluorhaltigen Polymeren, thermoplastischen Polyurethanen oder beliebigen Kombinationen dieser Materialien. Die Abdeckung (1, 5) kann als Platte, Folie oder Verbundfolie ausgestaltet sein. Die Rückseite (3, 6) sollte witterungsstabil sein, eine niedrige Wasserdampfdurchlässigkeit sowie einen hohen elektrischen Widerstand aufweisen. Neben den genannten Materialien für die Vorderseite kann die Rückseite auch aus Polyamid, ABS oder einem anderen witterungsstabilen Kunststoff oder einem auf der Innenseite mit einer elektrisch isolierenden Schicht versehenen Metallplatte oder -folie bestehen. Die Rückseite (3, 6) kann als Platte, Folie oder Verbundfolie ausgestaltet sein.
Die Klebschicht (2) sollte folgende Eigenschaften aufweisen: hohe Transparenz von 350 nm bis 1 150 nm, gute Haftung auf Silicium, dem Aluminium-Rückseitenkontakt der Solarzelle, den verzinnten Vorderseitenkontakten, der Antireflexschicht der Solarzelle und dem Material der Abdeckung bzw. der Rückseite. Die Klebeschicht kann aus einer oder mehreren Klebefolien bestehen, die auf die Abdeckung und/oder die Rückseite auflaminiert sein können.
Die Klebefolien (2) sollten weich sein, um die Spannungen, die durch die unterschiedlichen thermischen Ausdehnungskoeffizienten von Kunststoff und Silicium entstehen, auszugleichen. Die Klebefolien (2) sollten einen E-Modul von weniger als 200 MPa und mehr als 1 MPa, bevorzugt weniger als 140 MPa und mehr als 10 MPa aufweisen und einen Schmelzpunkt unterhalb der Schmelztemperatur der Lötverbindungen der Solarzellen, typischerweise 180°C bis 220°C bzw. der Wärmeformbeständigkeit der elektrisch leitfähigen Klebstoffe, typischerweise oberhalb von 200°C. Die Klebefolie sollte außerdem einen hohen elektrischen Widerstand, geringe Wasseraufnahme, hohe Beständigkeit gegen UV-Strahlung und thermische Oxidation aufweisen, chemisch inert sein und einfach und ohne Vernetzung verarbeitbar sein.
In einer bevorzugten Ausführungsform der Erfindung bestehen die Abdeckung und die Rückseite aus Kunststofffolien oder -platten. Die Gesamtdicke der Abdeckung und Rückseite beträgt mindestens 2 mm, bevorzugt mindestens 3 mm. Dadurch sind die Solarzellen ausreichend vor mechanischen Einflüssen geschützt. Die Verklebung besteht aus mindestens einer Klebefolie aus einem thermoplastischen Polyurethan mit einer Gesamtdicke von 300 bis 1 000 µm.

Eine weitere bevorzugte Ausführungsform der Erfindung ist ein Solarmodul, bei dem Abdeckung und Rückseite aus Folien mit einer Dicke von weniger als 1 mm aus den oben genannten Materialien bestehen, wobei der Verbund auf einem geeigneten Metall- oder Kunststoffträger fixiert ist, der dem gesamten die nötige Steifheit verleiht. Besonders bevorzugt handelt es sich bei dem Kunststoffträger um einen glasfaserverstärkten Kunststoff.

Eine weitere bevorzugte Ausführungsform der Erfindung ist ein Solarmodul, bei dem die Abdeckung aus einer Folie mit einer Dicke von weniger als 1 mm aus den oben genannten Materialien besteht und die Rückseite aus einer Hohlkammerplatte aus Kunststoff zur Erhöhung der Steifigkeit bei deutlicher Gewichtsreduzierung.

Bei einer weiteren bevorzugten Ausführungsform der Erfindung besteht die Abdeckung (103) und/oder die Rückseite (113) aus streifenförmigen Folien und Platten, die genau die Größe eines Solarzellenstrings haben. Diese sind in einem Abstand von wenigen Millimetern bis Zentimetern auf der Klebefolie 102 bzw. 111 fixiert, so dass zwischen den Strings ein Bereich nur mit Klebefolie ohne Abdeckung oder Rückseite existiert, der z.B. als Folienscharnier (131) dienen kann (siehe Fig. 7). Ein derartiges Solarmodul ist entweder faltbar und/oder aufrollbar, so dass es beispielsweise einfacher transportierbar ist. Besonders bevorzugt ist dieses Solarmodul aus leichten Kunststoffen aufgebaut, so dass es im Campingbereich, im Outdoor-Bereich oder bei sonstigen Mobilanwendungen wie Handy, Laptop etc. Verwendung findet.

Ein weiterer Gegenstand der Erfindung ist ein Verfahren zur Herstellung der erfindungsgemäßen Photovoltaik-Module, welche dadurch gekennzeichnet sind, dass die Photovoltaik-Module in einem Vakuumplattenlaminator (Vakuumheißpresse) oder in einem Rollenlaminator hergestellt werden.

Die Laminiertemperatur liegt bevorzugt mindestens 20°C und höchstens 40°C über der Erweichungstemperatur $T_{erw}$ des verwendeten thermoplastischen Polyurethans.

Bevorzugt werden ein Verbund bestehend aus einer Abdeckplatte oder Abdeckfolie und einer Kunststoffklebefolie, einem Solarzellenstring sowie ein Verbund bestehend aus einer rückseitigen Folie oder Platte und einer Kunststoffklebefolie über einen Rollenlaminator geschickt und dabei zum Solarmodul gepresst und verklebt.

Ein Rollenlaminator besteht aus mindestens zwei gegenläufigen Walzen, die sich mit einer definierten Geschwindigkeit drehen und mit einem definierten Druck einen Verbund verschiedener Materialien bei einer definierten Temperatur aufeinanderpressen.

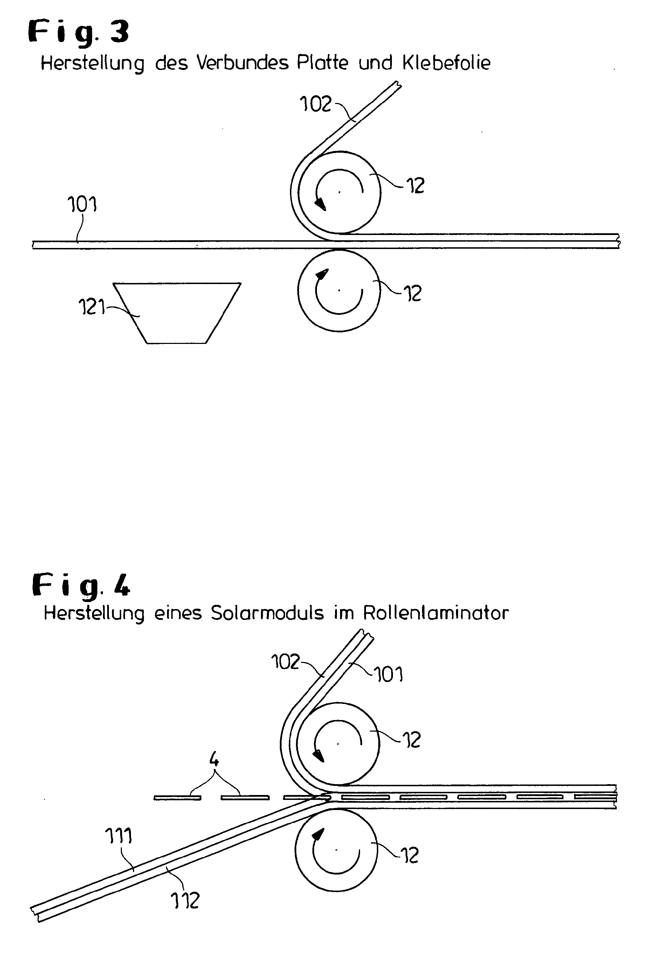

In einer bevorzugten Ausführungsform des Verfahrens werden im ersten Schritt Laminate aus einer Platte oder Folie (101) und der Klebefolie (102) in einem Rollenlaminator (12) hergestellt (siehe Fig. 3). Dieser Rollenlaminator kann sich direkt hinter dem Extruder zum extrudieren der Folien befinden. Danach werden im zweiten Schritt in einem Rollenlaminator (12) folgende Verbunde/Schichten übereinander eingeführt: Verbund aus Abdeckung (101) mit Klebefolie (102); Solarstrings (4); Verbund aus Rückseite (112) mit Klebefolie (111) (siehe Fig. 4). Die Klebefolien sind dabei jeweils auf die Innenseite der Abdeckung bzw. der Rückseite auflaminiert oder koextrudiert. Bei einer Dicke von mehr als 1 mm bei der Abdeckung oder der Rückseite kann diese aufgrund der geringen Wärmeleitung nicht mehr von einer Walze in einem Rollenlaminator erwärmt werden. In einem derartigen Fall ist dann eine Strahlungsheizung oder eine anders geartete Vorheizung nötig, um die Platte auf eine entsprechende Temperatur vorzuwärmen. Im Rollenlaminator sollte die Temperatur so hoch sein, dass die Klebefolien alle Zwischenräume zwischen den Solarzellen/ Solarzellenstrings ausfüllen und miteinander verschweißt werden, ohne dass dabei die Solarzellen zerbrochen werden.

Auf diese Weise ist es möglich, beliebig große Solarmodule herzustellen, ohne dass Luftblasen im fertigen Modul auftreten und dadurch die Qualität des Moduls negativ beeinflusst wird.

Die Vorschubgeschwindigkeit mit der die Folien in einem Rollenlaminator verarbeitet werden, beträgt vorzugsweise 0,1 m/min bis 3 m/min, besonders bevorzugt 0,2 m/min bis 1 m/min.

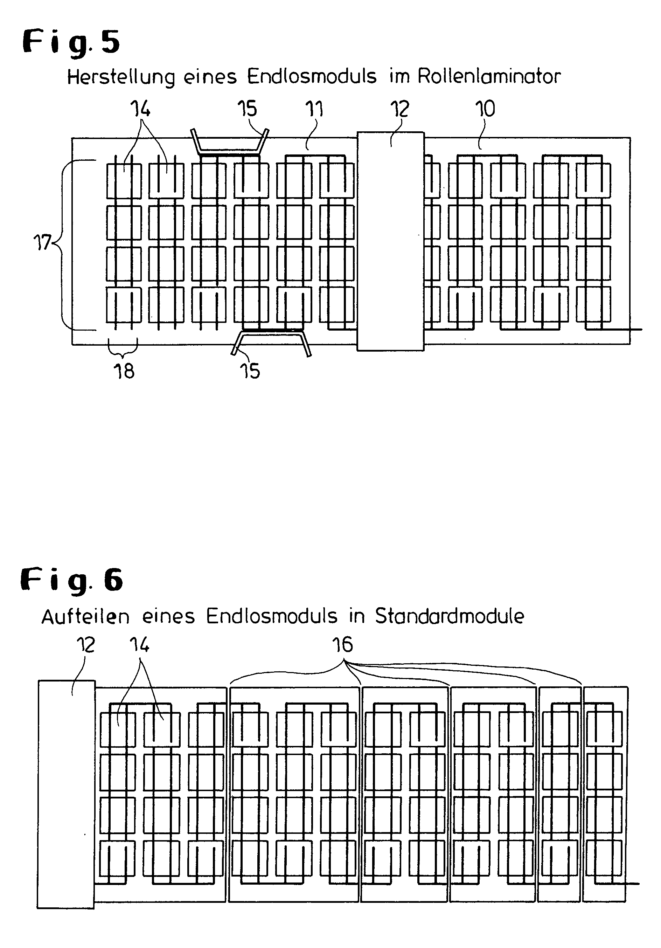

In einer weiteren bevorzugten Ausführungsform des Verfahrens wird das Solarmodul als Endlos-Solarmodul gefertigt, d.h., dass Abdeckung (10), Rückseite (11) und Solarzellenstrings (14) in einem Endlosverfahren durch den Rollenlaminator (12) miteinander verklebt werden (siehe Fig. 5). Dabei werden die verlöteten oder verklebten Solarzellenstrings quer zur Laminierrichtung auf der Rückseitenfolien positioniert. Bevor die Strings dann zur Walze kommen, werden sie rechts und links mit dem vorherigen bzw. nachfolgenden String in einer dem Fachmann geläufigen Weise verlötet (15) oder mit leitfähigen Klebstoffen verbunden. So kann ein beliebig langes Modul hergestellt werden. Nachdem das Modul laminiert ist, kann es in verschiedene Längen zerteilt werden, wobei die Breite immer der Stringlänge (17) und die Länge einem Vielfachen der Stringbreite (18) entspricht. Die Module werden mit einer Schneideinrichtung entlang der Linien (16) geschnitten (siehe Fig. 6).

Als aliphatische Diisocyanate (A) können aliphatische und cycloaliphatische Diisocyanate oder Gemische dieser Diisocyanate verwendet werden (vgl. HOUBEN-WEYL "Methoden der organischen Chemie", Band E20 "Makromolekulare Stoffe", Georg Thieme Verlag, Stuttgart, New York 1987, S. 1587-1593 oder Justus Liebigs Annalen der Chemie, 562, Seiten 75 bis 136).

Im einzelnen seien beispielhaft genannt: aliphatische Diisocyanate wie Ethylendiisocyanat, 1,4-Tetramethylendiisocyant, 1,6-Hexamethylendiisocyanat, 1,12-Dodecandiisocyanat; cycloaliphatische Diisocyanate wie Isophorondiisocyanat, 1,4-Cyclohexandiisocyanat, 1-Methyl-2,4-cyclohexandiisocyanat und 1-Methyl-2,6-cyclohexandiisocyanat sowie die entsprechenden Isomerengemische, 4,4'-Dicyclohexylmethandiisocyanat, 2,4'-Dicyclohexylmethandiisocyanat und 2,2'-Dicyclohexylmethandiisocyanat sowie die entsprechenden Isomerengemische. Vorzugsweise verwendet werden 1,6-Hexamethylendiisocyanat, 1,4-Cyclohexandiisocyanat, Isophorondiisocyanat und Dicyclohexylmethandiisocyanat sowie deren Isomerengemische. Die genannten Diisocyanate können einzeln oder in Form von Mischungen untereinander zur Anwendung kommen. Sie können auch zusammen mit bis zu 15 Mol-% (berechnet auf Gesamt-Diisocyanat) eines Polyisocyanates verwendet werden, es darf aber höchstens soviel Polyisocyanat zugesetzt werden, dass ein noch thermoplastisch verarbeitbares Produkt entsteht.

Zerewitinoff-aktive Polyole (B), die erfindungsgemäß eingesetzt werden, sind solche mit im Mittel mindestens 1,8 bis höchstens 3,0 zerewitinoff-aktiven Wasserstoffatomen und einem zahlenmittleren Molekulargewicht $\overline{M}_n$ von 600 bis 10000, vorzugsweise 600 bis 6000.

Eingeschlossen sind neben Aminogruppen, Thiolgruppen oder Carboxylgruppen aufweisenden Verbindungen insbesondere zwei bis drei, bevorzugt zwei Hydroxylgruppen aufweisende Verbindungen, speziell solche mit zahlenmittleren Molekulargewichten $\overline{M}_n$ von 600 bis 10000, besonders bevorzugt solche mit einem zahlenmittleren Molekulargewicht $\overline{M}_n$ von 600 bis 6000; z.B. Hydroxylgruppen aufweisende Polyester, Polyether, Polycarbonate und Polyesteramide.

Geeignete Polyether-Diole können dadurch hergestellt werden, dass man ein oder mehrere Alkylenoxide mit 2 bis 4 Kohlenstoffatomen im Alkylenrest mit einem Startermolekül, das zwei aktive Wasserstoffatome gebunden enthält, umsetzt. Als Alkylenoxide seien z.B. genannt: Ethylenoxid, 1,2-Propylenoxid, Epichlorhydrin und 1,2-Butylenoxid und 2,3-Butylenoxid. Vorzugsweise Anwendung finden Ethylenoxid, Propylenoxid und Mischungen aus 1,2-Propylenoxid und Ethylenoxid. Die Alkylenoxide können einzeln, alternierend nacheinander oder als Mischungen verwendet werden. Als Startermoleküle kommen beispielsweise in Betracht: Wasser, Aminoalkohole, wie N-Alkyl-diethanolamine, beispielsweise N-Methyl-diethanolamin und Diole wie Ethylenglykol, 1,3-Propylenglykol, 1,4-Butandiol und 1,6-Hexandiol. Gegebenenfalls können auch Mischungen von Startermolekülen eingesetzt werden. Geeignete Polyetherole sind ferner die hydroxylgruppenhaltigen Polymerisationsprodukte des Tetrahydrofurans. Es können auch trifunktionelle Polyether in Anteilen von 0 bis 30 Gew.-% bezogen auf die bifunktionellen Polyether eingesetzt werden, jedoch höchstens in solcher Menge, dass ein noch thermoplastisch verarbeitbares Produkt entsteht. Die im wesentlichen linearen Polyether-Diole besitzen vorzugsweise zahlenmittlere Molekulargewichte $\overline{M}_n$ von 600 bis 10000, besonders bevorzugt 600 bis 6000. Sie können sowohl einzeln als auch in Form von Mischungen untereinander zur Anwendung kommen.

Geeignete Polyester-Diole können beispielsweise aus Dicarbonsäuren mit 2 bis 12 Kohlenstoffatomen, vorzugsweise 4 bis 6 Kohlenstoffatomen, und mehrwertigen Alkoholen hergestellt werden. Als Dicarbonsäuren kommen beispielsweise in Betracht: aliphatische Dicarbonsäuren wie Bernsteinsäure, Glutarsäure, Adipinsäure, Korksäure, Azelainsäure und Sebacinsäure, oder aromatische Dicarbonsäuren, wie Phthalsäure, Isophthalsäure und Terephthalsäure. Die Dicarbonsäuren können einzeln oder als Gemische, z.B. in Form einer Bernstein-, Glutar- und Adipinsäuremischung, verwendet werden. Zur Herstellung der Polyester-Diole kann es gegebenenfalls vorteilhaft sein, anstelle der Dicarbonsäuren die entsprechenden Dicarbonsäurederivate, wie Carbonsäurediester mit 1 bis 4 Kohlenstoffatomen im Alkoholrest, Carbonsäureanhydride oder Carbonsäurechloride zu verwenden. Beispiele für mehrwertige Alkohole sind Glykole mit 2 bis 10, vorzugsweise 2 bis 6 Kohlenstoffatomen, z.B. Ethylenglykol, Diethylenglykol, 1,4-Butandiol, 1,5-Pentandiol, 1,6-Hexandiol, 1,10-Decandiol, 2,2-Dimethyl-1,3-propandiol, 1,3-Propandiol oder Dipropylenglykol. Je nach den gewünschten Eigenschaften können die mehrwertigen Alkohole allein oder in Mischung untereinander verwendet werden. Geeignet sind ferner Ester der Kohlensäure mit den genannten Diolen, insbesondere solchen mit 4 bis 6 Kohlenstoffatomen, wie 1,4-Butandiol oder 1,6-Hexandiol, Kondensationsprodukte von ω-Hydroxycarbonsäuren wie ω-Hydroxycapronsäure oder Polymerisationsprodukte von Lactonen, z.B. gegebenenfalls substituierten ω-Caprolactonen. Als Polyester-Diole vorzugsweise verwendet werden Ethandiol-polyadipate, 1,4-Butandiolpolyadipate, Ethandiol-1,4-butandiolpolyadipate, 1,6-Hexandiol-neopentylglykolpolyadipate, 1,6-Hexandiol-1,4-butandiolpolyadipate und Polycaprolactone. Die Polyester-Diole besitzen mittlere Molekulargewichte $\overline{M}_n$ von 600 bis 10000, besonders bevorzugt 600 bis 6000 und können einzeln oder in Form von Mischungen untereinander zur Anwendung kommen.

Zerewitinoff-aktive Polyole (C) sind sogenannte Kettenverlängerungsmittel und besitzen im Mittel 1,8 bis 3,0 zerewitinoff-aktive Wasserstoffatome und haben ein zahlenmittleres Molekulargewicht von 60 bis 500. Hierunter versteht man neben Aminogruppen, Thiolgruppen oder Carboxylgruppen aufweisenden Verbindungen solche mit zwei bis drei, bevorzugt zwei Hydroxylgruppen.

Als Kettenverlängerungsmittel werden vorzugsweise aliphatische Diole mit 2 bis 14 Kohlenstoffatomen eingesetzt, wie z.B. Ethandiol, 1,2-Propandiol, 1,3-Propandiol, 1,4-Butandiol, 2,3-Butandiol, 1,5-Pentandiol, 1,6-Hexandiol, Diethylenglykol und Dipropylenglykol. Geeignet sind jedoch auch Diester der Terephthalsäure mit Glykolen mit 2 bis 4 Kohlenstoffatomen, z.B. Terephthalsäure-bis-ethylenglykol oder Terephthalsäure-bis-1,4-butandiol, Hydroxyalkylenether des Hydrochinons, z.B. 1,4-Di(β-hydroxyethyl)-hydrochinon, ethoxylierte Bisphenole, z.B. 1,4-Di(β-hydroxyethyl)-bisphenol A, (cyclo)aliphatische Diamine, wie Isophorondiamin, Ethylendiamin, 1,2-Propylendiamin, 1,3-Propylendiamin, N-Methyl-propylen-1,3-diamin, N,N'-Dimethylethylendiamin und aromatische Diamine, wie 2,4-Toluylendiamin, 2,6-Toluylendiamin, 3,5-Diethyl-2,4-toluylendiamin oder 3,5-Diethyl-2,6-toluylendiamin oder primäre mono-, di-, tri- oder tetraalkylsubstituierte 4,4'-Diaminodiphenylmethane. Besonders bevorzugt werden als Kettenverlängerer Ethandiol, 1,4-Butandiol, 1,6-Hexandiol, 1,4-Di(β-hydroxyethyl)-hydrochinon oder 1,4-Di(β-hydroxyethyl)-bisphenol A verwendet. Es können auch Gemische der oben genannten Kettenverlängerer eingesetzt werden. Daneben können auch kleinere Mengen an Triolen zugesetzt werden.

Gegenüber Isocyanaten monofunktionelle Verbindungen können in Anteilen bis zu 2 Gew.-%, bezogen auf aliphatisches thermoplastisches Polyurethan, als sogenannte Kettenabbrecher eingesetzt werden. Geeignet sind z.B. Monoamine wie Butyl- und Dibutylamin, Octylamin, Stearylamin, N-Methylstearylamin, Pyrrolidin, Piperidin oder Cyclohexylamin, Monoalkohole wie Butanol, 2-Ethylhexanol, Octanol, Dodecanol, Stearylalkohol, die verschiedenen Amylalkohole, Cyclohexanol und Ethylenglykolmonomethylether.

Die relativen Mengen der Verbindungen (B) und (C) werden bevorzugt so gewählt, dass das Verhältnis der Summe der Isocyanatgruppen in (A) zu der Summe der zerewitinoffaktiven Wasserstoffatome in (B) und (C) 0,85:1 bis 1,2:1 beträgt, bevorzugt 0,95:1 bis 1,1:1.

Die erfindungsgemäß eingesetzten, thermoplastischen Polyurethanelastomere (TPU) können als Hilfs- und Zusatzstoffe (D) bis zu maximal 20 Gew.-%, bezogen auf die Gesamtmenge an TPU, der üblichen Hilfs- und Zusatzstoffe enthalten. Typische Hilfs- und Zusatzstoffe sind Katalysatoren, Pigmente, Farbstoffe, Flammschutzmittel, Stabilisatoren gegen Alterungs- und Witterungseinflüsse, Weichmacher, Gleit- und Entformungsmittel, fungistatisch und bakteriostatisch wirkende Substanzen sowie Füllstoffe und deren Mischungen.

Geeignete Katalysatoren sind die nach dem Stand der Technik bekannten und üblichen tertiären Amine, wie z.B. Triethylamin, Dimethylcyclohexylamin, N-Methylmorpholin, N,N'-Dimethylpiperazin, 2-(Dimethylamino-ethoxy) ethanol, Diazabicyclo[2,2,2]octan und ähnliche sowie insbesondere organische Metallverbindungen wie Titansäureester, Eisenverbindungen oder Zinnverbindungen wie Zinndiacetat, Zinndioctoat, Zinndilaurat oder die Zinndialkylsalze aliphatischer Carbonsäuren wie Dibutylzinndiacetat oder Dibutylzinndilaurat oder ähnliche. Bevorzugte Katalysatoren sind organische Metallverbindungen, insbesondere Titansäureester, Eisen- und Zinnverbindungen. Die Gesamtmenge an Katalysatoren in den TPU beträgt in der Regel etwa 0 bis 5 Gew.-%, bevorzugt 0 bis 2 Gew.-%, bezogen auf die Gesamtmenge an TPU.

Beispiele für weitere Zusatzstoffe sind Gleitmittel, wie Fettsäureester, deren Metallseifen, Fettsäureamide, Fettsäureesteramide und Siliconverbindungen, Antiblockmittel, Inhibitoren, Stabilisatoren gegen Hydrolyse, Licht, Hitze und Verfärbung, Flammschutzmittel, Farbstoffe, Pigmente, anorganische und/oder organische Füllstoffe und Verstärkungsmittel. Verstärkungsmittel sind insbesondere faserartige Verstärkungsstoffe wie z.B. anorganische Fasern, die nach dem Stand der Technik hergestellt werden und auch mit einer Schlichte beaufschlagt sein können. Nähere Angaben über die genannten Hilfs- und Zusatzstoffe sind der Fachliteratur, beispielsweise der Monographie von J.H. Saunders und K.C. Frisch "High Polymers", Band XVI, Polyurethane, Teil 1 und 2, Verlag Interscience Publishers 1962 bzw. 1964, dem Taschenbuch für Kunststoff-Additive von R.Gächter u. H.Müller (Hanser Verlag München 1990) oder der DE-A 29 01 774 zu entnehmen.

Weitere Zusätze, die in das TPU eingearbeitet werden können, sind Thermoplaste, beispielsweise Polycarbonate und Acrylnitril/Butadien/Styrol-Terpolymere, insbesondere ABS. Auch andere Elastomere wie Kautschuk, Ethylen/Vinylacetatcopolymere, Styrol/Butadiencopolymere sowie andere TPU können verwendet werden.

Weiterhin zur Einarbeitung geeignet sind handelsübliche Weichmacher wie Phosphate, Phthalate, Adipate, Sebacate und Alkylsulfonsäureester.

Die Herstellung der TPU kann diskontinuierlich oder kontinuierlich durchgeführt werden. Kontinuierlich können die TPU beispielsweise mit dem Mischkopf/Bandverfahren oder dem sogenannten Extruder-Verfahren hergestellt werden. Im Extruder-Verfahren, z.B. in einem Mehrwellenextruder, kann die Dosierung der Komponenten A), B) und C) gleichzeitig, d.h. im oneshot-Verfahren, oder nacheinander, d.h. nach einem Prepolymer-Verfahren, erfolgen. Dabei kann das Prepolymer sowohl batchweise vorgelegt als auch kontinuierlich in einem Teil des Extruders oder in einem separaten, vorgeschalteten Prepolymeraggregat hergestellt werden.

Die Erfindung soll anhand des nachfolgenden Beispiels näher erläutert werden.

## Beispiel 1

Aus Texin® DP7-3007 (Handelsprodukt der Bayer Corp., Härte: 58 Shore D) wurde eine Folie auf eine Makrofol®-Folie folgendermaßen aufextrudiert:

Auf einem Extruder mit einer Walzenanlage der Fa. Reifenhäuser (mit einer Kühlwalze (Chill roll)) wurde eine vertikale Düsenanordnung angebracht. Vor der Gießwalze der Anlage befand sich eine Presseurwalze mit gummierter Oberfläche. Die Düse wurde zwischen Gießwalze und Presseurwalze positioniert. Zur Erreichung einer für diese "Chill-roll"-Anlage sehr langsamen Abzugsgeschwindigkeit wurde der Folien-Verbund nur durch einen Wickler abgezogen. Zur Verbesserung der Haftung der Texin®-Schmelze auf der eingesetzten Makrofol®-Folie DE 1-1 (mit einer Dicke von 375 µm (Handelsprodukt der Bayer AG)) wurde die Makrofol®-Folie vor Zulauf der Schmelze mit IR-Strahlern vorgeheizt. Das Texin® wurde 6 h bei 60°C im Trockenlufttrockner vorgetrocknet.

Es wurden nachstehende Verarbeitungsparameter eingestellt:

| | |
|---|---|
| Düsentemperatur | 180°C |
| Massetemperatur des Texins® | 186°C |
| Druck vor der Düse | 75 bar |
| Drehzahl des Extruders | 80 UpM |
| Temperatur an der Gießwalze | 20°C |
| Temperatur an der Kühlwalze (Chill roll) | 10°C |
| Abzugsgeschwindigkeit | 3 m/min |

Die so hergestellte Verbundfolie wurde dann als Abdeckung mit der Texin®-Seite nach unten und als Rückseite mit der Texin®-Seite nach oben mit dazwischen angebrachten Solarzellenstrings mittels 160°C heißer Rollen in einem Rollenlaminator aufeinanderlaminiert. Zur optimalen Verklebung wurden die Verbundfolien mit einem IR-Strahler vorgeheizt. Die Transportgeschwindigkeit des Rollenlaminators betrug 0,3 m/min. Die 15 x 15 cm$^2$ großen Module konnten in 30 Sekunden hergestellt werden.
Es wurden mehrere blasenfreie Solarmodule (Module 1, 2 und 3) hergestellt, in die die Solarzellen riss- und bruchfrei eingebettet waren.
Der Wirkungsgrad der Solarzellen blieb durch den Herstellungsprozess unverändert.
Die Solarmodule wurden in zwei unterschiedlichen Tests bewittert. Die Wirkungsgrade vor und nach der Bewitterung sind in der Tabelle angegeben.

**Beispiel 2**

Aus Desmopan® 88382 (Handelsprodukt der Bayer AG, Härte: 80 Shore A) wurde eine Folie folgendermaßen extrudiert:
Neben einem Extruder mit horizontaler Düsenanordung wurde eine Walzenanlage der Firma Somatec (mit einer Kühlwalze (Chill roll)) angebracht. Die Chill roll wurde ca. 5 cm unterhalb der Düse positioniert. Zur Erreichung einer für diese "Chill-roll"-Anlage sehr langsamen Abzugsgeschwindigkeit wurde die Folie nur durch einen Wickler abgezogen. Das Desmopan® wurde 6 h bei 75°C im Trockenlufttrockner vorgetrocknet.
Es wurden nachstehende Verarbeitungsparamter eingestellt:

| | |
|---|---|
| Düsentemperatur | 170°C |
| Massetemperatur des Desmopans® | 177°C |
| Druck vor der Düse | 27 bar |
| Drehzahl des Extruders | 40 UpM |
| Temperatur an der Kühlwalze (Chill roll) | 10°C |
| Abzugsgeschwindigkeit | 1,7 m/min |

Die so hergestellte Folie wurde dann als Klebefolie in einem Solarmodul wie in Fig. 1 beschrieben eingesetzt. Die Vorderseite des 15 x 15 cm$^2$ großen Moduls bestand aus gehärtetem Weißglas und die Rückseite aus einer Tedlar-PET-Tedlar-Verbundfolie. Die Solarmodule wurden bei 150°C innerhalb von 10 Minuten in einem Vakuumlaminator hergestellt.
Es wurden mehrere blasenfreie Solarmodule (Module 4 und 5) hergestellt, in die die Solarzellen riss- und bruchfrei eingebettet waren.
Der Wirkungsgrad der Solarzellen blieb durch den Herstellungsprozess unverändert.
Die Solarmodule wurden in zwei unterschiedlichen Tests bewittert. Die Wirkungsgrade vor und nach der Bewitterung sind in der Tabelle angegeben.

**Vergleich**

Es wurden Vergleichsmodule (Vergleichsmodul 1 und 2) hergestellt. Anstelle des Texin® DP7-3007 wurde EVA (Ethyl-Vinylacetat) als Klebefolie eingesetzt. Die Herstellungszeit der 15 x 15 cm$^2$ großen Module betrug 20 Minuten und erfolgte im Vakuumlaminator. Die Vergleichsmodule wurden ebenfalls bewittert (siehe Tabelle).

| Modul | Wirkungsgrad vor Bewitterung | Wirkungsgrad nach Bewitterung im Klimawechsel Test* (IEC 6 12 15) | Wirkungsgrad nach Bewitterung im Damp Heat Test** (IEC 6 12 15) |
|---|---|---|---|
| 1 | 13,8% | 13,7% | - |
| 2 | 13,3% | 13,5% | - |
| 3 | 13,5% | - | 13,5% |
| 4 | 15,2% | 15,1% | - |
| 5 | 14,7% | - | 14,8% |
| Vergleich 1 | 13,2 % | 13,3 % | - |
| Vergleich 2 | 13,9% | - | 14,1% |

*50 Zyklen von -40°C bis +85°C bei einer Zykluslänge von ca. 6 h

**500 h bei 80°C und 85 % rel. Luftfeuchtigkeit

Der Messfehler bei der Wirkungsgradbestimmung beträgt ± 0,3 % absolut.

Der Wirkungsgrad wird nach IEC 6 12 15 gemessen.

Die erfindungsgemäßen Solarmodule haben die gleichen Wirkungsgrade wie die Vergleichsmodule (Stand der Technik) und weisen die gleiche mechanische Stabilität sowie Witterungsstabilität auf. Die Wirkungsgrade bleiben auch nach Bewitterung erhalten.

Die erfindungsgemäßen Solarmodule konnten jedoch erheblich schneller (Faktor 40 im Rollenlaminator und Faktor 2 im Vakuumlaminator) hergestellt werden als die Vergleichsmodule.

**Patentansprüche**

1.    Photovoltaik-Moldule mit folgendem Aufbau

A) mindestens einer vorderseitigen, der Energiequelle zugewandten, äußeren Abdeckschicht aus Glas oder einem schlagzähen, UV-stabilen, witterungsstabilen, transparenten Kunststoff mit geringer Wasserdampfdurchlässigkeit,

B) mindestens einer zwischen A) und C) befindlichen Kunststoffklebeschicht, in die mindestens eine oder mehrere Solarzellen, die untereinander elektrisch verbunden sind, eingebettet sind,

C) mindestens einer rückseitigen, der Energiequelle abgewandten, äußeren Schicht aus Glas oder einem witterungsstabilen Kunststoff mit niedriger Wasserdampfdurchlässigkeit,

**dadurch gekennzeichnet, dass** die Kunststoffklebeschicht in B) aus einem aliphatischen thermoplastischen Polyurethan mit einer Härte von 75 Shore A bis 70 Shore D und mit einer Erweichungstempeeratur $T_{erw}$ von 90°C bis 150°C bei einem E'-Modul von 2 MPa (gemessen nach der DMS-Methode) besteht, welches ein Reaktionsprodukt ist aus einem aliphatischen Diisocyanat (A), mindestens einem zerewitinoff-aktiven Polyol mit im Mittel mindestens 1,8 bis höchstens 3,0 zerewitinoff-aktiven Wasserstoffatomen und mit einem zahlenmittleren Molekulargewicht von 600 bis 10000 g/mol (B) und mindestens einem zerewitinoff-aktiven Polyol mit im Mittel mindestens 1,8 bis höchstens 3,0 zerewitinoff-aktiven Wasserstoffatomen und mit einem zahlenmittleren Molekulargewicht von 60 bis 500 g/mol als Kettenverlängerer (C), wobei das Molverhältnis der NCO-Gruppen des aliphatischen Diisocyanats zu den zerewitinoff-aktiven Wasserstoffatomen aus (B) und (C) 0,85 bis 1,2, bevorzugt 0,9 bis 1,1 beträgt.

2.    Photovoltaik-Modul gemäß Anspruch 1, **dadurch gekennzeichnet, dass** die Abdeckschicht A) aus einer Platte oder aus einer oder mehreren Folien besteht.

3.    Photovoltaik-Modul gemäß Anspruch 1, **dadurch gekennzeichnet, dass** die Schicht C) aus einer Platte oder aus einer oder mehreren Folien besteht.

**4.** Photovoltaik-Modul gemäß Anspruch 1, **dadurch gekennzeichnet, dass** es sich bei der Abdeckschicht A) um eine in Streifen vorliegende Folie oder Platte handelt, wobei die Streifen über den sogenannten Solarzellenstrings angeordnet sind.

**5.** Photovoltaik-Modul gemäß Anspruch 1, **dadurch gekennzeichnet, dass** die in der Kunststoffklebeschicht B) eingebetteten Solarzellen in Solarzellenstrings angeordnet sind.

**6.** Photovoltaik-Modul gemäß Anspruch 5, **dadurch gekennzeichnet, dass** die Solarzellenstrings seriell hintereinander verlötet oder mit leitfähigen Klebstoffen verbunden sind.

**7.** Photovoltaik-Modul gemäß Anspruch 5, **dadurch gekennzeichnet, dass** die elektrische Verbindung zwischen den Solarzellen aus leitfähigen Klebstoffen besteht, die vorzugsweise als Raupen direkt auf der Innenseite der Klebschicht (B) angebracht sind, so dass sie beim Laminieren direkt auf die entsprechenden Kontakte der Solarzellen treffen.

**8.** Photovoltaik-Modul gemäß einem oder mehrerer der Ansprüche 1 bis 7, **dadurch gekennzeichnet, dass** in der Kunststoffklebeschicht (B) zwischen Abdeckschicht (A) und den Solarzellen zusätzlich eine Glasfolie mit einer Dicke von weniger als 500 μm vorhanden ist.

**9.** Verfahren zur Herstellung der Photovoltaik-Module gemäß einem der Ansprüche 1 bis 8, **dadurch gekennzeichnet, dass** das Photovoltaik-Modul in einem Vakuumplattenlaminator (Vakuumheißpresse) oder in einem Rollenlaminator hergestellt wird.

**10.** Verfahren gemäß Anspruch 9, **dadurch gekennzeichnet, dass** ein Verbund bestehend aus einer Abdeckplatte oder Abdeckfolie A) und einer Kunststoffklebefolie B), einem Solarzellenstring sowie ein Verbund bestehend aus einer rückseitigen Folie oder Platte und einer Kunststoffklebefolie über einen Rollenlaminator geschickt werden und dabei zum Solarmodul gepresst und verklebt werden.

# **F i g. 1**

Erfindungsgemäßes Solarmodul mit Abdeckplatte und Rückseitenfolie

# **F i g. 2**

Erfindungsgemäßes Solarmodul mit Abdeckfolie und Rückseitenplatte

# Fig. 3

Herstellung des Verbundes Platte und Klebefolie

# Fig. 4

Herstellung eines Solarmoduls im Rollenlaminator

# Fig. 5

Herstellung eines Endlosmoduls im Rollenlaminator

# Fig. 6

Aufteilen eines Endlosmoduls in Standardmodule

# Fig. 7

Faltbares Solarmodul mit Folienscharnier

# Fig. 8

Elektrische Verbindung der Solarzellen mit
elektrisch leitfähigen Klebstoffen